Europäisches Patentamt

European Patent Office

Office européen des brevets

(19)

(11) Publication number: **0 015 554**
**B1**

## (12) EUROPEAN PATENT SPECIFICATION

(45) Date of publication of patent specification: **20.06.84**

(51) Int. Cl.³: **H 03 K  5/24,** H 03 K  13/09

(21) Application number: **80101131.3**

(22) Date of filing: **06.03.80**

(54) Comparator circuit.

(30) Priority: **06.03.79 JP  25864/79**

(43) Date of publication of application:
**17.09.80 Bulletin 80/19**

(45) Publication of the grant of the patent:
**20.06.84 Bulletin 84/25**

(84) Designated Contracting States:
**DE FR GB**

(56) References cited:
**US - A - 3 227 895**
**US - A - 3 577 194**
**US - A - 3 811 125**
**US - A - 3 956 708**
**US - A - 4 114 149**

(73) Proprietor: **NEC CORPORATION**
**33-1, Shiba 5-chome, Minato-ku**
**Tokyo 108 (JP)**

(72) Inventor: **Hareyama,Kyuichiuc/OUNEC Corporation**
**33-1, Shibi Gochome Minato-ku**
**Tokyo (JP)**

(74) Representative: **Glawe, Delfs, Moll & Partner**
**Patentanwälte**
**Postfach 26 01 62 Liebherrstrasse 20**
**D-8000 München 26 (DE)**

## Description

The present invention relates to a comparator circuit, and more particularly, to a high speed comparator circuit suitable for an analog to dital (A/D) converter.

Various types of comparator circuits in the prior art had, in many cases, a satisfactory response speed for signals fed from a low impedance signal source. However it was difficult for them to attain a satisfactory response speed in a comparison operation for signals fed from a high impedance signal source because a large time constant was provided by the high impedance of the signal source and a parasitic capacitance at the input section of the comparator circuit.

From US—A—3 227 895 there has been known a comparator circuit of the type comprising a differential amplifier circuit having a pair of input terminals, means for supplying a fixed potential to a first of said input terminals, means for supplying a variable potential to a second of said input terminals during a predetermined period, short circuiting means connected between said input terminals for operatively completing a short circuit therebetween, and control means for controlling said short circuiting means, said short circuiting means including a transistor coupled directly between said first and second input terminals and being driven responsive to said control means to short circuit said input terminals.

In this prior art comparator circuit, a bipolar transistor is connected between a pair of input terminals of a differential amplifier and made conductive prior to respective comparison operation for the purpose of calibration. However, electric charges are accumulated at the pair of input terminals of the amplifier through the same operating period, and hence fast change in the input signal cannot be detected accurately within the same operating period. As a result, high speed operation of this comparator is still limited.

It is an object of the present invention to provide a comparator circuit of the aforementioned type which can achieve a high speed operation even for signals fed from a high impedance signal source, and which can be easily realized in the form of an integrated circuit device.

For achieving this object the invention provides a comparator circuit of the aforementioned type, which is characterized in that said control means is adapted to periodically drive said short circuiting means to complete said short circuit a plurality of times during said predetermined period, whereby the potential at said second input terminal is periodically made equal to said fixed potential during said predetermined period every time when said short circuiting means is driven into the conducting state.

It is an important advantage of the invention that by periodically short circuiting the input terminals of the differential amplifier a plurality of times during a comparison period, any potential difference between the two input terminals will be kept at a very small value throughout the comparison period. Therefore the effective time constant associated to the pair of input terminals will be very small, which provides the possibility of a high speed comparison operation. Also the comparator circuit according to the present invention is particularly suited for being applied to an A/D converter circuit, especially of the sequential comparison type.

Further preferred and advantageous features of the invention are indicated in the dependent claims.

The above-mentioned and other features and objects of the present invention will become more apparent by reference to the following description of preferred embodiments of this invention taken in conjunction with the accompanying drawings, wherein:

Fig. 1 is a block diagram showing a prior art comparator circuit;

Fig. 2 is a block diagram showing another prior art comparator circuit;

Fig. 3 is a waveform diagram showing the operations of the prior art comparator circuit;

Fig. 4 is a block diagram showing a basic construction of a comparator circuit according to the present invention;

Fig. 5 is a block diagram showing another comparator construction according to the present invention;

Fig. 6 is a waveform diagram showing the operations of the circuit illustrated in Fig. 5;

Fig. 7 is a circuit diagram showing one preferred embodiment of the present invention;

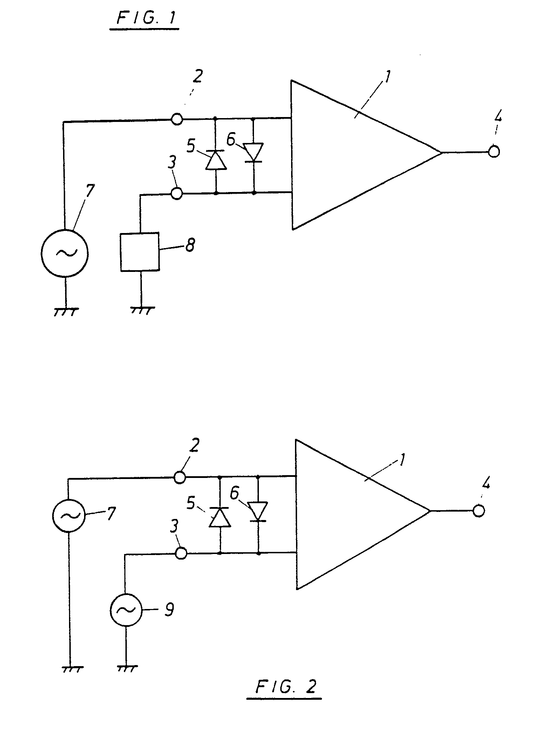

Examples of prior art comparator circuits in which comparison between a signal fed from a high impedance signal source and a reference voltage or a signal fed from another signal source are illustrated in Figs. 1 and 2, respectively.

Referring to Fig. 1, diodes 5 and 6 are connected between input terminals 2 and 3 of a differential amplifier 1 in a parallel bidirectional relation to clamp the amplitude of a differential input. To the input terminal 2 is connected a signal source 7, and to the input terminal 3 is connected a reference voltage source 8. An excessive amplitude of the signal source 7 is clamped by the diodes 5 and 6 with their forward voltages, and thereby speed-up of the comparison operations can be achieved.

In another known example shown in Fig. 2, in place of the reference voltage source 8, another signal source 9 is connected to the input terminal 3 of the differential amplifier 1. The other component parts are the same as those shown in Fig. 1 and are designated by the same reference numerals. In this example also, the diodes 5 and 6 operate as a clamp circuit for suppressing an excessive differential input, and thus contribute to speed-up of the comparison operations. However, such diodes also act as large junction capacitors at the same time, and accordingly, they cause a large time constant at the input end.

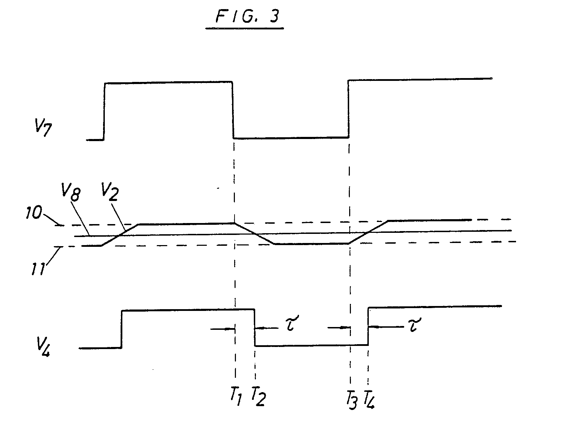

Now the operations of the prior art comparator circuit shown in Fig. 1 will be explained with reference to Fig. 3. Voltage levels 10 and 11 correspond to clamp voltages for the differential input due to the diodes 5 and 6.

If the input signal $V_7$ of the signal source 7 changes from a high level to a low level at time $T_1$, then the level $V_2$ at the input terminal 2 of the differential amplifier 1 begins to fall from this time point in accordance with a time constant that is determined by parasitic capacitance of the diodes 5 and 6 and the impedance of the signal source 7 per se. When the input terminal level $V_2$ becomes lower than the level $V_8$ of the reference signal source 8 at time $T_2$, the output $V_4$ at the output terminal 4 of the comparator is turned from a high level to a low level, and thus a comparison output $V_4$ based on comparison operation between the input signal $V_7$ and the reference signal $V_8$ can be generated. As described above, the comparison output $V_4$ provided is delayed by the period $\tau$ from time $T_1$ to time $T_2$ due to the time constant formed at the input end of the differential amplifier 1. Likewise, when the input signal $V_7$ changes from a low level to a high level at time $T_3$, the input terminal level $V_2$ becomes higher than the reference signal $V_8$ with a delay of the period $\tau$ from time $T_3$ to time $T_4$, and thus the level change in the comparison output $V_4$ of the comparator from the low level to the high level also appears with the same delay $\tau$.

As described above, there occurred a large delay in the comparison operation of the known comparator circuits, so that it was difficult for such comparator circuits to achieve high speed operation. It is to be noted that if the diodes 5 and 6 for clamping are not provided in the input section of the differential amplifier 1, then the amplitude at the input terminal 2 would be approximately equal to the amplitude of the input signal 7. Hence the amount of change in electric charge at the input terminal 2 caused by the level change of the input signal $V_7$ becomes so large that obviously the comparison operation would be further delayed.

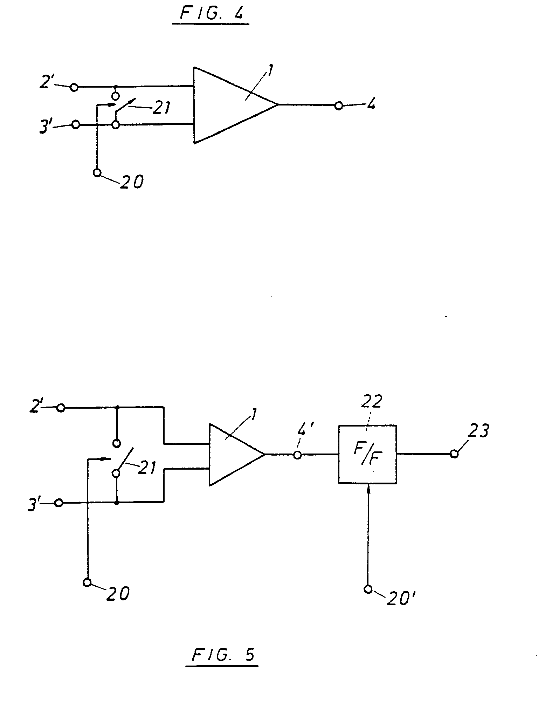

Now the comparator circuit according to the present invention will be explained with reference to Figs. 4 to 6.

A basic structure of the comparator circuit according to the present invention is illustrated in Fig. 4. An electronic switch 21 is connected between a signal input terminal 2' and a reference signal input terminal 3' of a differential amplifier 1, and opening and closing of this electronic switch 21 is controlled by a control signal $C_{20}$ applied to a control terminal 20. When the electronic switch 21 is brought to a closed state, it gives a zero input to the differential amplifier 1 in a moment, and thereby immediately removes the level difference between the input terminals 2' and 3'. Subsequently when the electronic switch 21 becomes opened, a level difference appears between the input terminals 2' and 3' at a high speed without being affected by the parasitic capacitances. In this case, only the negligible time constant caused by the parasitic capacitance of the input wiring would affect the operation. Accordingly, if the gain of the differential amplifier 1 is sufficiently high, then at the moment when the electronic switch 21 turns to its opened state, the output of the differential amplifier 1 would shift to high or low level in response to the differential input.

Another basic structure of the comparator circuit according to the present invention is illustrated in Fig. 5. In this structure, a latch circuit 22 such as a flip-flop is added to the circuit shown in Fig. 4 by being coupled to the output terminal 4' of the differential amplifier 1. A control signal $C_{20'}$ is applied to a control terminal 20' of this latch circuit 22 which in turn responds to the control signal $C_{20'}$ for latching the output data from the differential amplifier 1 to output the comparison data through an output terminal 23. Owing to this latch action for the output data, stabilization of the data against noises and the like can be achieved. In the operation of this comparator circuit, the control signal 20' brings the latch circuit 22 into a write state after the control signal 20 has turned the switch 21 off and the output of the differential amplifier 1 has been established.

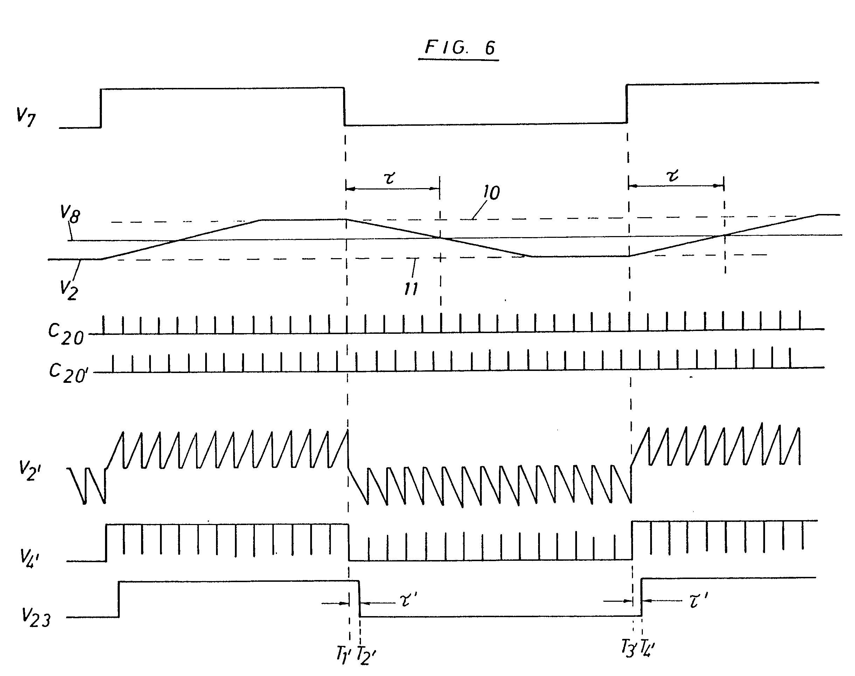

The principle of operation of the comparator circuit shown in Fig. 5 will now be explained with reference to Fig. 6, in which for convenience of contrast to the prior art circuit, the corresponding waveforms in the operation of the prior art comparator circuit illustrated in Fig. 3 are jointly depicted and the common portions to those in Fig. 3 are given the same reference numerals and letters.

In the illustrated example, two control signals $C_{20}$ and $C_{20'}$ are in a different phase relationship. The switch 21 is periodically closed in response to a first control signal $C_{20}$ to suppress an unnecessary amplitude at the input terminal 2' to which the input signal $V_7$ is applied and to remove electric charge at the input section, thereby to produce a level $V_{2'}$ at the input terminal 2'. The differential amplifier 1 responds to the differential input as soon as the switch 21 becomes open to produce an output $V_{4'}$. Subsequently thereto, in response to a second control signal $C_{20'}$ the output $V_{4'}$ of the differential amplifier 1 is written in the latch circuit 22 and thereafter the output data is latched in the latch circuit 22 until the next write operation. The response time $\tau'$ of the comparator circuit according to the present invention is about one-half of the period of the control signal $C_{20}$, and hence, the present invention can greatly improve the response time $\tau'$ of the comparator circuit as compared to the delay time $\tau$ that was inevitable for the prior art comparator circuit.

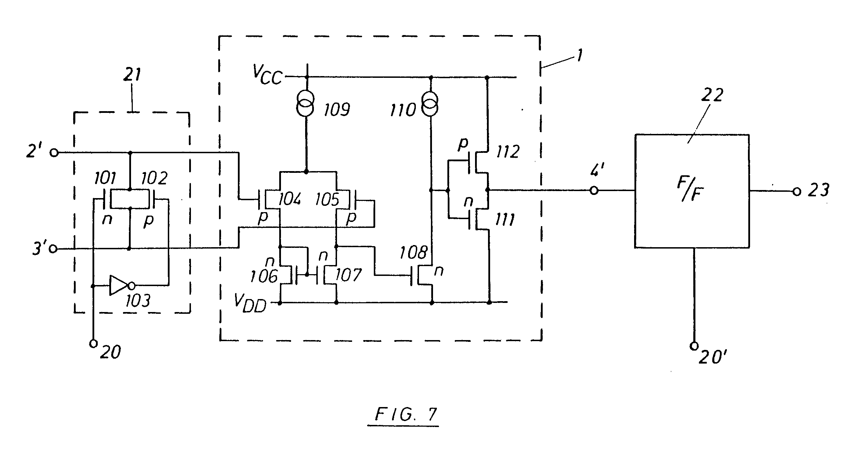

Now one preferred embodiment of the comparator circuit according to the present invention as realized in a monolithic integrated circuit form will be explained with reference to Fig. 7. The circuit portions common to those shown in Fig. 4 or 5 are designated by the same reference numerals.

An N-channel insulated gate field effect transistor (FET) 101 and P-channel FET 102 and an inverter 103 form the electronic switch 21. The differential amplifier 1 is composed of an input stage consisting of P-channel FET's 104 and 105, an active load consisting of n-channel FET's 106 and 107, a driver stage consisting of a FET 108, current sources 109 and 110 for biasing the input stage and the driver stage, and an output inverter stage formed of FET's 111 and 112. The output 4' of the differential amplifier 1 is fed to a well-known flip-flop circuit 22.

As described in detail, the comparator circuit according to the present invention can greatly improve a response speed by making use of a very simple circuit structure, and furthermore, the present invention gives implementation for realizing such a comparator circuit in a monolithic integrated circuit form and thus largely contributes to the developments in this technical field.

## Claims

1. A comparator circuit comprising a differential amplifier circuit (1) having a pair of input terminals (2', 3'), means for supplying a fixed potential to a first of said input terminals, means for supplying a variable potential to a second of said input terminals during a predetermined period, short circuiting means (21) connected between said input terminals for operatively completing a short circuit therebetween, and control means (20) for controlling said short circuiting means, said short circuiting means including a transistor (101) coupled directly between said first and second input terminals and being driven responsive to said control means to short circuit said input terminals, characterised in that said control means is adapted to periodically drive said short circuiting means to complete said short circuit a plurality of times during said predetermined period, whereby the potential at said second input terminal is periodically made equal to said fixed potential during said predetermined period every time when said short circuiting means is driven into the conducting state.

2. The circuit according to claim 1, characterized by further comprising a latch circuit (22) for storing the comparison result obtained by comparing said variable potential with said fixed potential during those times of said predetermined period when said short circuiting means is in the non-conductive state.

3. The circuit according to claim 1, characterized in that said control means (20) includes means for supplying said short-circuiting means (21) with a first clock signal.

4. The circuit according to claims 2 and 3, characterized by further comprising means (20') for providing said latch circuit with a second clock signal as write control signal, the phase of said second clock signal being different from said first clock signal.

5. The circuit according to claim 3, wherein said short-circuiting circuit (21) includes an N-channel field effect transistor (101) and a P-channel field effect transistor (102) connected in parallel.

## Revendications

1. Circuit comparateur comprenant un circuit amplificateur différentiel (1) ayant une paire de bornes d'entrée (2', 3'), un moyen pour fournir un potentiel fixe à une première borne des bornes d'entrée, un moyen pour fournir un potentiel variable à la seconde borne d'entrée pendant une période prédéterminée, un moyen de court-circuitage (21) branché entre les bornes d'entrée pour compléter un court-circuit créé entre ces bornes, et un moyen de commande (20) pour commander le moyen de court-circuitage, ce moyen de court-circuitage comportant un transistor (101) branché directement entre la première et la seconde borne d'entrée et commandé en réponse au moyen de commande dans le but de court-circuiter les bornes d'entrée, caractérisé en ce que le moyen de commande est destiné à commander périodiquement le moyen de court-circuitage de manière à compléter le circuit de court-circuit un certain nombre de fois au cours de la période prédéterminée, d'où il résulte que le potentiel à la seconde borne d'entrée est rendu périodiquement égal au potentiel fixe lors de la période prédéterminée chaque fois que le moyen de court-circuitage est mis à l'état conducteur.

2. Circuit selon la revendication 1, caractérisé en ce qu'il comprend en outre un circuit à bascule (22) pour stocker le résultat de la comparaison obtenu en comparant le potentiel variable au potentiel fixe lors des moments de la période prédéterminée où le moyen de court-circuitage se trouve à l'état non conducteur.

3. Circuit selon la revendication 1, caractérisé en ce que le moyen de commande (20) comprend un moyen pour fournir au moyen de court-circuitage (21) un premier signal d'horloge.

4. Circuit selon les revendications 2 et 3, caractérisé en ce qu'il comprend en outre un moyen (20') pour fournir au circuit à bascule un second signal d'horloge comme signal de commande d'écriture, la phase de ce second signal d'horloge étant différente de celle du premier signal d'horloge.

5. Circuit selon la revendication 3, où le circuit de court-circuitage (21) comprend un transistor (101) à effet de champ à canal N et un transistor (102) à effet de champ à canal P connectés en parallèle.

**Patentansprüche**

1. Vergleichsschaltung mit einer Differenzverstärkerschaltung (1) mit einem Paar von Eingangsklemmen (2', 3'), einer Vorrichtung zum Anlegen eines festen Potentials an die erste Eingangsklemme, mit einer Vorrichtung zum Anlegen eines variablen Potentials während einer vorbestimmten Zeitspanne an die zweite Eingangsklemme, mit einer Kurzschlußvorrichtung (21), die zwischen die beiden Eingangsklemmen geschaltet ist, um im Betrieb einen Kurzschluß dazwischen herzustellen, und mit einer Steuervorrichtung (20) zum Steuern der Kurzschlußvorrichtung, wobei die Kurzschlußvorrichtung einen Transistor (101) aufweist, der direkt zwischen die erste und zweite Eingangsklemme geschaltet ist und in Abhängigkeit von der Steuervorrichtung betrieben wird, um die beiden Eingangsklemmen kurzzuschließen, dadurch gekennzeichnet, daß die Steuervorrichtung so ausgestaltet ist, daß sie periodisch die Kurzschlußvorrichtung so treiben kann, daß der Kurzschluß eine Vielzahl von Malen während der vorbestimmten Zeitspanne hergestellt wird, wodurch das Potential an der zweiten Eingangsklemme während der vorbestimmten Zeitspanne periodisch jedesmal gleich dem festen Potential gemacht wird, wenn die Kurzschlußvorrichtung in ihren leitfähigen Zustand gesetzt wird.

2. Vergleichsschaltung nach Anspruch 1, dadurch gekennzeichnet, daß sie ferner eine Halteschaltung (22) aufweist zum Speichern des Vergleichsergebnisses, welches erhalten wird durch den Vergleich des variablen Potentials mit dem festen Potential während der Zeiten während der vorbestimmten Zeitspanne, in welchen die Kurzschlußvorrichtung in ihrem nicht leitfähigen Zustand ist.

3. Vergleichsschaltung nach Anspruch 1, dadurch gekennzeichnet, daß die Steuervorrichtung (20) eine Vorrichtung aufweist zum Anlegen eines ersten Taktsignals an die Kurzschlußvorrichtung (21).

4. Vergleichsschaltung nach Anspruch 2 oder 3, dadurch gekennzeichnet, daß sie ferner aufweist eine Vorrichtung (20') zum Versorgen der Halteschaltung mit einem zweiten Taktsignal als Schreibsteuersignal, wobei die Phase des zweiten Taktsignals unterschiedlich von der des ersten Taktsignals ist.

5. Vergleichsschaltung nach Anspruch 3, dadurch gekennzeichnet, daß die Kurzschlußschaltung (21) einen N-Kanal-Feldeffekttransistor (101) und einen P-Kanal-Feldeffekttransistor (102) aufweist, die parallel zueinander geschaltet sind.

<u>F I G. 1</u>

<u>F I G. 2</u>

*FIG. 3*

_FIG. 4_

_FIG. 5_

FIG. 6

FIG. 7